# FASCICULE DE BREVET EUROPEEN

(11) **EP 4 127 736 B1**
(45) Date de publication et mention de la délivrance du brevet: **10.01.2024**
(21) Numéro de dépôt: 21732363.3
(22) Date de dépôt: 24.03.2021
(51) Int. Cl.: G01R 15/18

(54) **CAPTEUR DE COURANT A TRES LARGE BANDE PASSANTE**
STROMSENSOR MIT SEHR GROSSER BANDBREITE
VERY-WIDE-BANDWIDTH CURRENT SENSOR

(30) Priorité: 02.04.2020 FR 2003328
(43) Date de publication de la demande: 08.02.2023
(73) Titulaire: Safran Electrical & Power, 31702 Blagnac (FR)
(72) Inventeur: CIMA, Lionel, 77550 Moissy-Cramayel (FR)
(74) Mandataire: Cabinet Beau de Loménie
(86) Numéro de dépôt international: PCT/FR2021/050504
(87) Numéro de publication internationale: WO 2021/198589

(56) Documents cités:
- EP-A1- 1 596 205
- EP-A1- 2 742 887
- CN-A- 107 390 081
- DE-A1-102017 215 722
- FR-A1- 2 831 704
- KR-B1- 101 317 220
- US-A1- 2007 236 208
- US-A1- 2014 253 109
- US-A1- 2014 333 290
- US-B1- 6 313 623
- US-B1- 6 366 076
- KARRER N ET AL: "A NEW CURRENT MEASURING PRINCIPLE FOR POWER ELECTRONIC APPLICATIONS", 11TH. INTERNATIONAL SYMPOSIUM ON POWER SEMICONDUCTOR DEVICES AND IC S. ISPSD 99. PROCEEDINGS. TORONTO, MAY 26 - 28, 1999; [INTERNATIONAL SYMPOSIUM ON POWER SEMICONDUCTOR DEVICES & IC'S], NEW YORK, NY : IEEE, US, 26 May 1999 (1999-05-26), pages 279-282, XP000903590, ISBN: 978-0-7803-5291-9
- TROSTER NATHAN ET AL: "Improvements of a Coaxial Current Sensor with a Wide Bandwidth Based on the HOKA Principle", 2018 20TH EUROPEAN CONFERENCE ON POWER ELECTRONICS AND APPLICATIONS (EPE'18 ECCE EUROPE), EPE ASSOCIATION, 17 September 2018 (2018-09-17), XP033433262, [retrieved on 2018-10-30]
- KARRER N ET AL: "A NEW CURRENT PROBE WITH A WIDE BANDWIDTH", 8TH EUROPEAN CONFERENCE ON POWER ELECTRONICS AND APPLICATIONS. LAUSANNE, CH, SEPT. 7 - 9, 1999; [EPE . EUROPEAN CONFERENCE ON POWER ELECTRONICS AND APPLICATIONS], EPE ASSOCIATION, BRUSSELS, BE, vol. 8, 7 September 1999 (1999-09-07), pages 1-10, XP000883005, ISBN: 978-90-75815-04-7

## Description

### Domaine Technique

L'invention concerne la mesure de courant circulant dans un conducteur, et plus particulièrement la mesure de courant par des dispositifs de type Rogowski à large bande passante.

### Technique antérieure

Parmi les capteurs de courant à large bande de fréquence, il existe notamment des capteurs de courant de type transformateur de courant qui permettent d'assurer une séparation galvanique entre le mesurant et la mesure. Pour des applications large bande, il est nécessaire d'avoir un noyau de perméabilité relative élevée sur toute la bande de fréquence. Cela les rend sensible aux courants continus qui vont saturer leur noyau magnétique et ainsi dégrader la mesure. Ils sont également encombrants et de masse élevée.

Un autre type de capteur a été développé pour réaliser des mesures de courants alternatifs insensible aux courants continus et utilisables sur une large gamme de fréquence : les capteurs de courant de type Rogowski, comme celui notamment divulgué dans le document US 6 313 623. Ils permettent de déterminer la valeur d'un courant traversant un conducteur à partir d'une tension générée par le courant dans des bobines à air ou à noyau faiblement magnétique ou amagnétique, la tension générée étant proportionnelle à la dérivée temporelle du courant. Ce type de capteur est relativement compact et est insensible aux composantes continues du courant du fait de l'absence de noyau magnétique dans la bobine. Toutefois, ce type de capteur ne fonctionne que pour des plages de fréquences limitées, soit à des basses fréquences, typiquement de 0,1 Hz à 100 kHz, soit à des hautes fréquences, typiquement de 100 kHz à 300 MHz.

Il est donc souhaitable de disposer d'un dispositif de mesure de courant compact permettant de couvrir une bande de fréquence allant de la basse fréquence à la haute fréquence, tout en étant immunisé aux variations rapides de tension, de courant et aux dérives en température.

### Exposé de l'invention

L'invention concerne un circuit électrique de mesure d'un courant circulant dans un conducteur comprenant :
- une première paire de bobines de type Rogowski reliées en série, les bobines de type Rogowski de la première paire étant aptes à fonctionner dans une première bande de fréquence ;
- une deuxième paire de bobines de type Rogowski reliées en série, les bobines de type Rogowski de la deuxième paire étant aptes à fonctionner dans une seconde bande de fréquence, la seconde bande de fréquence comprenant au moins en partie des fréquences supérieures aux fréquences de la première bande de fréquence ; et
- un moyen de blindage électrique de la première paire de bobines de type Rogowski,
et dans lequel un noyau des bobines de type Rogowski des première et deuxième paires a une perméabilité relative inférieure à 10 et dans lequel, une bobine de chaque paire comprend au moins un enroulement multi-spires, l'autre bobine de la paire comprenant au moins un enroulement multi-spires enroulé en sens opposé.

On entend par bobine un dipôle de forme annulaire constitué par au moins un enroulement multi-spires délimitant un espace interne de la bobine. L'espace interne de la bobine est ainsi l'espace de mesure autour du conducteur, dans lequel circule le courant à mesurer, délimité par les enroulements multi-spires des bobines.

Au sein d'une paire de bobines de type Rogowski, les enroulements sont enroulés dans des sens opposés afin de constituer une structure différentielle permettant de rejeter les couplages capacitifs.

Le blindage de la première paire permet de limiter la bande passante des bobines de la première paire et de les protéger contre les variations temporelles rapides de tension et de courant ainsi que contre les résonances parasites.

Le fait d'avoir une paire de bobines de type Rogowski pour une première bande de fréquence et une seconde paire pour une deuxième bande de fréquence permet de couvrir une large bande passante pour la mesure de courant tout en conservant un excellent rapport signal sur bruit.

Les noyaux des bobines des deux paires ont une perméabilité relative inférieure à 10 pour ne pas perturber la mesure de courant par des composantes continues du courant.

Selon une caractéristique particulière de l'invention, la première bande de fréquence est dédiée à la basse fréquence, typiquement de 0,1 Hz à 100 kHz.

Selon une autre caractéristique particulière de l'invention, la seconde bande de fréquence est dédiée à la haute fréquence, typiquement au-delà de 100 kHz.

Selon une autre caractéristique particulière de l'invention, les moyens de blindage de la première paire de bobines sont une spire en court-circuit entourant les deux bobines de la première paire. La spire de court-circuit permet ainsi de limiter l'intensité du champ magnétique dans les bobines de la première paire pour éviter les phénomènes de claquage lors des variations rapides d'intensité, pour assurer une fonction d'écran électrostatique pour protéger les bobines en cas de variations rapides en tension et de dégrader le coefficient de qualité du bobinage de la deuxième paire pour réduire voire annuler les résonances parasites en haute fréquence.

Selon une autre caractéristique particulière de l'invention, le noyau des bobines est amagnétique ou superparamagnétique. Cela permet d'augmenter la sensibilité des bobines sans introduire de non-linéarité.

Selon une autre caractéristique particulière de l'invention, les bobines de type Rogowski de la première paire comprennent un nombre pair de couches d'enroulement. Une bobine de la première paire comprend par exemple deux enroulements multi-spires concentriques, le deuxième enroulement multi-spires étant formé par le fil de retour de la bobine de type Rogowski sur le premier enroulement multi-spires. Le fait d'avoir un nombre pair de couches d'enroulements, au lieu d'utiliser le fil de retour central des bobines de type Rogowski, dans la première paire permet d'augmenter la sensibilité. L'augmentation de la sensibilité s'accompagne cependant d'une diminution de la bande passante, c'est pourquoi cela est utilisé de préférence sur la première paire de bobines.

Selon un mode de réalisation, le circuit comprend également au moins un moyen de filtrage d'un mode commun de la première paire placé à des bornes de la première paire.

Selon un autre mode de réalisation, le circuit comprend également au moins un moyen de filtrage d'un mode commun de la deuxième paire placé à des bornes de la deuxième paire.

Le filtrage de mode commun des paires de bobines permet d'atténuer le courant en sortie des deux paires créé par la dérive temporelle en tension. Le filtrage peut être réalisé par des condensateurs, et plus particulièrement par des condensateurs à trois terminaux de type X2Y^{®}. Pour la première paire, dédiée aux fréquences basses, le filtrage peut également comprendre des éléments inductifs. Le fait d'utiliser des condensateurs de type X2Y^{®} permet de réaliser un circuit de mesure plus compact, moins coûteux et plus adapté aux hautes fréquences et pouvant augmenter la bande passante.

Selon un autre mode de réalisation, le circuit électrique comprend également :
- un premier filtre de type HOKA dont au moins une entrée est reliée à la première paire ; et
- un second filtre de type HOKA dont des entrées sont reliées à la deuxième paire et à une sortie du premier filtre de type HOKA.

Les filtres de type HOKA sont définis dans l'article de N. Karrer et P. Hoffer-Noser, « A new current measuring principle for power electronic applications », 1999 et ils permettent de combiner les différents signaux arrivant en entrée de ces filtres. Ainsi le second filtre de type HOKA combine les signaux venant de la deuxième paire et les signaux en sortie du premier filtre de type HOKA. Le premier filtre de type HOKA peut combiner les signaux venant de la première paire avec d'autres signaux fournis en entrée du premier filtre. Si le premier filtre de type HOKA ne reçoit en entrée que les signaux venant de la première paire, il agira alors comme un filtre passe-bas du premier ordre.

Les deux filtres de type HOKA placés en sortie des première et deuxième paires de bobines permettent d'intégrer le signal récupéré en sortie des bobines pour pouvoir déterminer la valeur de courant circulant dans le conducteur. En effet, le signal récupéré en sortie des deux paires de bobines de type Rogowski est une tension générée par la circulation du courant dans le conducteur, cette tension étant proportionnelle à la dérivée temporelle du courant circulant dans le conducteur. De plus, grâce à l'utilisation de deux paires de bobines de type Rogowski dédiée chacune à une bande de fréquence, on peut déterminer la valeur du courant dans le conducteur grâce au circuit de mesure selon l'invention sur une large bande passante et avec un niveau de bruit très faible.

Les deux filtres de type HOKA peuvent être des filtres analogiques ou des filtres numériques.

Le circuit de mesure selon l'invention permet ainsi de réaliser une mesure à sortie différentielle du courant circulant dans le conducteur. La sortie différentielle permet d'améliorer l'immunité du capteur en environnement électromagnétique sévère.

Selon une caractéristique particulière de l'invention, le circuit comprend également un capteur de courant continu dont la sortie est placée en entrée du premier filtre de type HOKA. Ainsi, le premier filtre de type HOKA combinera les signaux issus de la première paire et les signaux issus du capteur de courant continu.

L'ajout d'un capteur de courant continu permet d'augmenter la bande passante du capteur de courant et ainsi de pouvoir également mesurer des courants continus.

Selon une autre caractéristique particulière de l'invention, le capteur de courant continu est un capteur à effet Néel^{®}.

Selon une autre caractéristique particulière de l'invention, les première et deuxième paires sont présentes sur au moins un circuit imprimé.

Selon une autre caractéristique particulière de l'invention, les première et deuxième paires sont présentes sur au moins un support souple.

Un autre objet de l'invention est un capteur de courant comprenant un circuit électrique selon l'invention.

Un capteur de courant comprenant un circuit électrique selon l'invention permet d'obtenir un capteur de courant ayant un niveau de bruit très faible, de l'ordre de 0,01 % de la pleine échelle, capable de suivre des vitesses de variation de courant allant de 1 A/s jusqu'à 10 kA/s avec une bande passante couvrant la plage de 1 Hz à plus de 10 MHz.

Un autre objet de l'invention est un procédé de mesure d'un courant circulant dans un conducteur mis en oeuvre par le capteur de courant de l'invention comprenant au moins une étape d'enroulement des bobines de type Rogowski des première et deuxième paires autour dudit conducteur.

Le procédé selon l'invention permet de déterminer des courants circulant dans un conducteur grâce à l'utilisation d'un capteur de courant selon l'invention.

### Brève description des dessins

D'autres caractéristiques et avantages de la présente invention ressortiront de la description faite ci-dessous, en référence aux dessins annexés qui en illustrent des exemples de réalisation dépourvus de tout caractère limitatif.
[Fig. 1] La figure 1 représente, de manière schématique et partielle, un circuit électrique de mesure d'un courant selon un mode de réalisation de l'invention.
[Fig. 2A] La figure 2A représente, de manière schématique et partielle, une partie du circuit électrique de mesure comprenant un filtrage de mode commun de la première paire de bobines de type Rogowski selon un autre mode de réalisation de l'invention.
[Fig. 2B] La figure 2B représente, de manière schématique et partielle, une partie du circuit électrique de mesure comprenant un filtrage de mode commun de la deuxième paire de bobines de type Rogowski selon un autre mode de réalisation de l'invention.
[Fig. 3] La figure 3 représente un circuit électrique de mesure pouvant réaliser des mesures différentielles de courant et comprenant un capteur de courant continu selon un autre mode de réalisation de l'invention.

### Description des modes de réalisation

Dans sa forme la plus simple, une bobine de type Rogowski est une bobine ayant un noyau à air. Néanmoins, on nomme actuellement bobine Rogowski des bobines ayant un noyau amagnétique ou ayant un noyau faiblement magnétique. Dans toute la description, on nommera bobine de type Rogowski une bobine ayant un noyau de perméabilité relative inférieure à 10 sur toute la bande passante couverte par le circuit de mesure de l'invention.

Comme indiqué précédemment, on entend par bobine un dipôle de forme annulaire constitué par au moins un enroulement multi-spires délimitant un espace interne de la bobine ainsi que l'espace de mesure autour du conducteur.

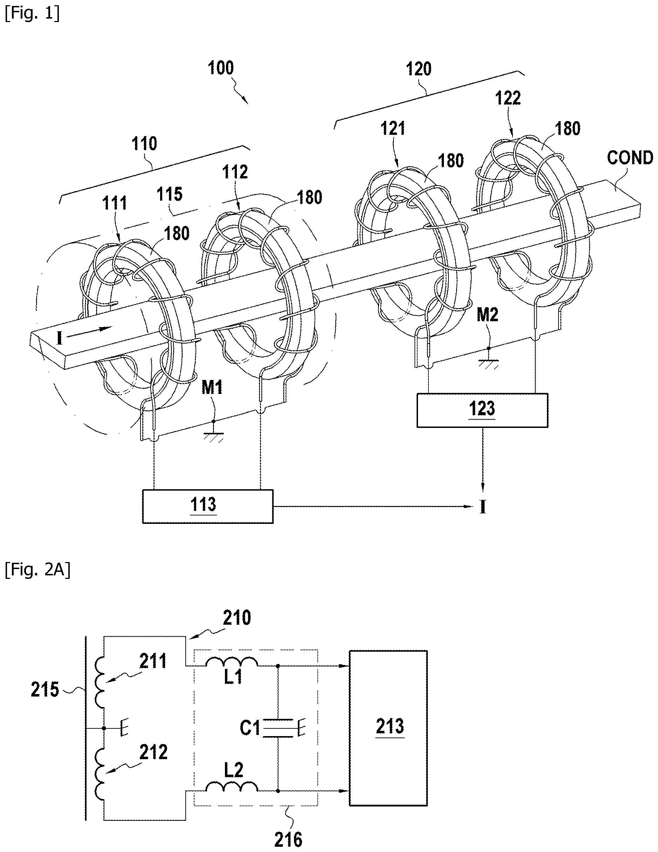

La figure 1 représente, de manière schématique et partielle, un circuit électrique de mesure 100 d'un courant I dans un conducteur COND selon un mode de réalisation de l'invention. Ce circuit 100 comprend une première paire 110 de bobines de type Rogowski 111 et 112. Les bobines de la première paire 110 comprennent chacune au moins un enroulement multi-spires. L'enroulement de la bobine 111 est enroulé dans un premier sens et l'enroulement de l'autre bobine 112 est enroulé dans un second sens, c'est-à-dire en sens opposé.

Le fait d'enrouler les enroulements des bobines d'une même paire dans des sens opposés va permettre de rejeter les couplages capacitifs entre le conducteur COND et les bobines 111 et 112. En effet, ce couplage capacitif apparaîtra en mode commun sur les deux bobines 111 et 112, alors que les forces électromotrices dues au courant I apparaîtront en mode différentiel. Les deux bobines 111 et 112 doivent alors être reliées entre elles en série, le « point milieu » M1 entre les deux bobines étant placé à un potentiel fixe, par exemple à une masse électrique. Une mesure de la tension de mode différentiel en sortie des deux bobines 111 et 112 permettra ainsi d'atténuer fortement le couplage capacitif qui apparaît en mode commun.

Le circuit 100 comprend également une seconde paire 120 de bobines de type Rogowski 121 et 122. Les bobines 121 et 122 comprennent chacune au moins un enroulement multi-spires. Les enroulements des bobines 121 et 122 sont enroulés en sens opposé de la même manière que pour les bobines 111 et 112 de la première paire 110 afin de rejeter les couplages capacitifs entre le conducteur COND et les bobines 121 et 122. Les bobines 121 et 122 sont reliées entre elles en série, et comme pour les bobines 111 et 112, leur « point milieu » M2 est placé à un potentiel fixe.

La première paire de bobines de type Rogowski 110 est dédiée à une première bande de fréquence et la deuxième paire 120 à une seconde bande de fréquence. La seconde bande de fréquence comprend au moins en partie des fréquences supérieures à celles de la première bande de fréquence. La première bande de fréquence sera par exemple dédiée à la basse fréquence tandis que la seconde bande de fréquence sera dédiée à la haute fréquence.

La première paire 110 est entourée d'une spire de court-circuit 115 qui assure un blindage électrique de la première paire 110. Ce blindage permet de limiter la bande passante des bobines 111 et 112 de la première paire 110 et de les protéger contre les fortes vitesses de variation de courant et d'amortir les résonnances parasites hautes fréquences de ces mêmes bobines.

Le noyau 180 des bobines des deux paires 110 et 120 est un noyau 180 présentant une perméabilité relative inférieure à 10, voire inférieure à 2, voire inférieure à 1,1.

Pour mesurer le courant I circulant dans un conducteur COND avec les bobines décrites précédemment, il faut placer le conducteur COND dans l'enroulement des bobines 111, 112, 121 et 122. La circulation du courant I dans le conducteur COND va générer une tension en sortie des deux paires 110 et 120 qui est proportionnelle à la dérivée du courant I. Ainsi pour déterminer la valeur du courant I, on intègre la tension récupérée en sortie des deux paires 110 et 120.

Pour cela, le circuit comprend deux filtres de type HOKA 113 et 123, placés en sortie des deux paires. Un des filtres de type HOKA 113 est donc placé en sortie de la première paire 110 et l'autre 123 en sortie de la deuxième paire 120. Ces filtres de type HOKA 113 et 123 sont constitués d'un filtre passe-bas du premier ordre et d'un additionneur. L'additionneur permet de combiner les signaux délivrés par l'ensemble constitué de la première paire et du filtre passe-bas, formant ainsi un capteur de courant apte à mesurer un courant en basse fréquence et les signaux délivrés par la deuxième paire qui forme un capteur de vitesse de variation de courant dI/dt apte à mesurer une vitesse de variation de courant en haute fréquence.

Le filtre passe-bas agit comme un simple filtre passe-bas pour le capteur de courant basse fréquence, tandis qu'il agit comme un intégrateur pour le capteur de variation de courant haute fréquence. Ainsi, le deuxième filtre de type HOKA permet de combiner les signaux délivrés par un capteur de courant basse fréquence et un capteur de variation de courant haute fréquence pour constituer un capteur de courant à plus large bande.

Grâce à ces deux filtres de type HOKA, on peut alors déterminer la valeur du courant à la fois dans la première bande de fréquence de la première paire 110 et dans la seconde bande de fréquence de la deuxième paire 120.

Selon une caractéristique particulière de l'invention, pour chacune des bobines Rogowski 111, 112, 121 et 122, le fil de retour est bobiné de manière à former un enroulement multi-spires. Ainsi, il est possible d'obtenir des bobines comprenant deux enroulements multi-spires. Ou, il est également possible qu'au sein d'une même paire, la première bobine soit formée par le premier enroulement multi-spires et que la deuxième bobine soit formée par le fil de retour bobiné en un enroulement multi-spires de la première bobine.

Selon une autre caractéristique particulière de l'invention, les bobines 111 et 112 de la première paire 110 comprennent plusieurs couches d'enroulements, et plus particulièrement, elles comprennent un nombre pair de couches d'enroulements concentriques superposés les uns sur les autres. En augmentant le nombre de couches de la première paire 110, on augmente la sensibilité des bobines tout en réduisant leur bande passante. C'est pourquoi, cela sera préférentiellement utilisé pour les bobines de la première paire 110.

Selon une autre caractéristique particulière de l'invention, le noyau 180 des bobines d'une paire 110 et/ou 120 est amagnétique.

Selon une autre caractéristique particulière de l'invention, le noyau 180 des bobines d'une paire 110 et/ou 120 est superparamagnétique.

Le fait que le noyau 180 soit superparamagnétique ou amagnétique permet d'influencer la sensibilité du circuit de mesure.

Selon une autre caractéristique particulière de l'invention, les bobines d'une paire 110 et/ou 120 sont des bobines à air. Leur noyau 180 est donc formé d'air.

Afin de simplifier les figures, le conducteur COND n'est pas représenté sur les figures 2A à 3. Dans les figures 2A à 3, les enroulements multi-spires des bobines de type Rogowski au sein d'une même paire sont enroulés en sens opposé et le noyau des bobines a une perméabilité relative inférieure à 10. De plus, la première paire de bobines est apte à fonctionner dans une première bande de fréquence et la deuxième paire dans une seconde bande de fréquence. La seconde bande de fréquence comprend au moins en partie des fréquences supérieures aux fréquences de la première bande de fréquence.

La figure 2A représente, de manière schématique et partielle, une partie du circuit électrique de mesure comprenant un filtrage de mode commun de la première paire de bobines de type Rogowski selon un autre mode de réalisation de l'invention.

Comme décrit précédemment, les deux bobines de type Rogowski 211 et 212 de la première paire 210 sont reliées entre elles en série et sont entourées d'un moyen de blindage magnétique et électrique 215, par exemple d'une spire de court-circuit 215. Un moyen de filtrage du mode commun 216 de la première paire 210 est placé aux bornes de ladite paire 210 afin de filtrer le mode commun des bobines 211 et 212. Le premier filtre de type HOKA 213 relié à la première paire de bobines 211 et 212 est placé à la suite du moyen de filtrage 216.

Le moyen de filtrage de mode commun 216 permet de réduire les courants de perturbations issus du mode commun de la première paire 210.

Le moyen de filtrage 216 comprend des éléments inductifs L1 et L2 ainsi qu'un composant capacitif C1.

Selon une caractéristique particulière de l'invention, l'élément capacitif C1 est un condensateur à trois terminaux, par exemple une capacité de type X2Y^{®}. Ce type de condensateur à céramique est plus compact que les condensateurs traditionnels, moins coûteux et peut supporter des fréquences plus élevées.

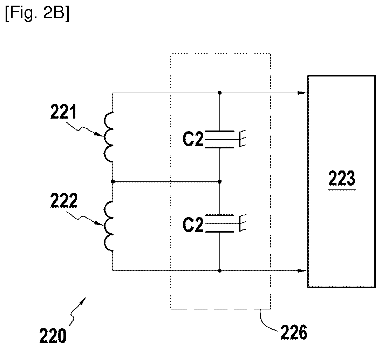

La figure 2B représente, de manière schématique et partielle, une partie du circuit électrique de mesure comprenant un filtrage de mode commun de la deuxième paire de bobines de type Rogowski selon un autre mode de réalisation de l'invention.

Comme décrit précédemment à la figure 1, les deux bobines de type Rogowski 221 et 222 de la deuxième paire 220 sont reliées entre elles en série.

Un moyen de filtrage du mode commun 226 de la deuxième paire 220 est placé aux bornes de ladite paire 220 afin d'en filtrer le mode commun. Le second filtre de type HOKA 223 relié à la deuxième paire de bobines 221 et 222 est placé à la suite du moyen de filtrage 226.

Le moyen de filtrage 226 permet de réduire les courants de perturbation issus du mode commun de la deuxième paire 220. Il comprend des éléments capacitifs C2 qui sont, par exemple des condensateurs en céramique X2Y^{®}. Ce type de condensateur est plus compact, moins coûteux et supporte des fréquences plus élevées que les condensateurs traditionnels.

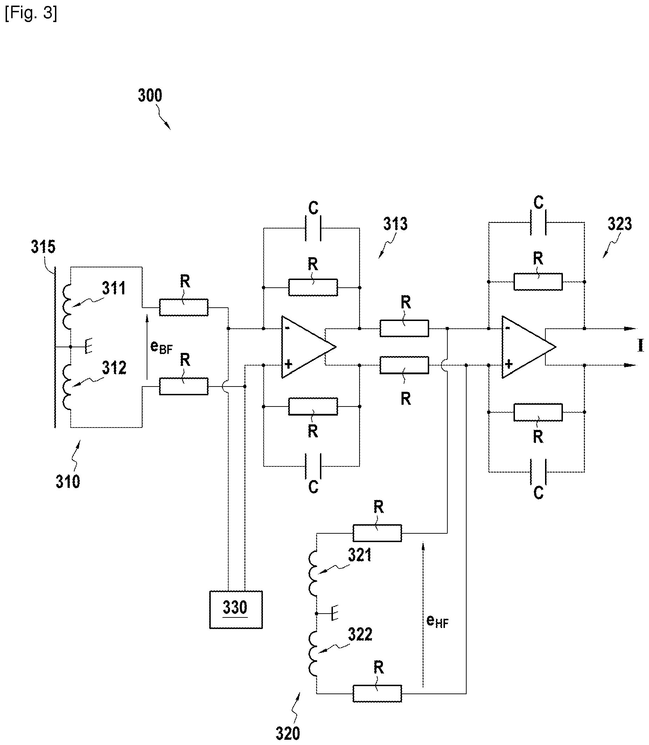

La figure 3 représente un circuit électrique 300 de mesure selon un autre mode de réalisation de l'invention.

Le circuit de mesure 300 comprend une première paire 310 de bobines de type Rogowski 311 et 312 dédiées aux basses fréquences et une deuxième paire 320 de bobines de type Rogowski 321 et 322 dédiées aux hautes fréquences. Au sein d'une même paire, les bobines sont reliées entre elles en série et ont des enroulements en sens opposé.

La première paire 310 est entourée d'une spire de court-circuit 315 pour limiter la bande passante des bobines 311 et 312 tout en les protégeant des résonnances parasites dues à une montée en fréquence et des fortes dérives en courant.

Un moyen de filtrage du mode commun de la première paire 310, tel que décrit en référence à la figure 2A peut être placé aux bornes de la première paire 310. De même qu'un moyen de filtrage du mode commun de la deuxième paire 320, tel que décrit en référence à la figure 2B peut être placé aux bornes de la deuxième paire 320.

La tension e_{BF} générée dans les bobines 311 et 312 de la première paire 310 par la circulation du courant I dans le conducteur est fournie en sortie de la première paire au premier filtre de type HOKA 313.

La tension e_{HF} générée dans les bobines 321 et 322 par la circulation du courant I dans le conducteur est fournie en sortie de la deuxième paire au second filtre de type HOKA 323.

Les deux filtres de type HOKA 313 et 323 permettent de combiner et d'intégrer les tensions e_{HF}, e_{BF} générées dans les deux paires 310 et 320 de bobines pour déterminer la valeur du courant I circulant dans le conducteur, que l'on soit en basse fréquence ou en haute fréquence.

Le circuit de mesure 300 peut également comprendre un capteur de courant continu 330 pour déterminer les courants continus ou les courants à très basse fréquence circulant dans le conducteur. Dans ce cas, le premier filtre de type HOKA 313 combine les signaux de la première paire 310 et du capteur 330, et le second filtre de type HOKA 323 combine les signaux en sortie du premier filtre de type HOKA 313 et de la deuxième paire 320. Le circuit de mesure 300 permet ainsi d'obtenir un capteur de courant à très large bande.

Selon une caractéristique particulière de l'invention, le capteur 330 de courant continu est un capteur à effet Néel^{®} qui permet une mesure précise des courants continus ou des courants à très faible fréquence.

Selon une autre caractéristique particulière de l'invention, les bobines de type Rogowski des deux paires sont présentes sur au moins un circuit imprimé.

Selon une autre caractéristique particulière de l'invention, les bobines de type Rogowski des deux paires sont présentes sur au moins un support souple.

L'invention concerne également un capteur de courant comprenant un circuit électrique de mesure tel que décrit en référence aux figures 1 à 3.

Le capteur selon l'invention peut permettre de réaliser des mesures ponctuelles de courant circulant dans des conducteurs. Il peut également être intégré à un dispositif plus complexe nécessitant des mesures régulières ou continues de courant dans un même conducteur.

L'invention concerne également un procédé de mesure d'un courant circulant dans un conducteur. Le procédé est mis en oeuvre par le capteur de mesure selon l'invention ou par l'un des circuits de mesure selon l'invention. Le conducteur est placé entre les bobines de type Rogowski des deux paires, de manière à ce que les bobines soient enroulées autour de ce conducteur. La circulation du courant dans le conducteur génère des tensions dans chaque paire de bobine qui sont ensuite combinées et intégrées pour pouvoir déterminer la valeur du courant circulant dans le conducteur quelle que soit la fréquence du courant.

Plus généralement, on peut mesurer, grâce au capteur selon l'invention, le courant circulant dans une pièce conductrice ou dans un composant électrique ou dans un circuit électrique externe au capteur et/ou ne pouvant être placé dans l'enroulement des bobines. Il suffit, en effet, d'enrouler les bobines du capteur autour d'un conducteur et de relier ce conducteur à la pièce, au composant ou au circuit, de manière à ce que le courant circulant dans cette pièce, ce composant ou ce circuit circule également dans le conducteur placé dans l'enroulement des bobines.

## Revendications

1. Capteur (100, 300) de mesure d'un courant électrique (I) circulant dans un conducteur (COND) comprenant :
- une première paire (110, 210, 310) de bobines de type Rogowski (111, 112, 211, 212, 311, 312) reliées en série, les bobines de type Rogowski de la première paire étant configurées pour mesurer le courant électrique (I) dans une première bande de fréquence ;
- une deuxième paire (120, 220, 320) de bobines de type Rogowski (121, 122, 221, 222, 321, 322) reliées en série, les bobines de type Rogowski de la seconde paire étant configurées pour mesurer le courant électrique (I) dans une seconde bande de fréquence, la seconde bande de fréquence comprenant au moins en partie des fréquences supérieures aux fréquences de la première bande de fréquence ; et
- un moyen de blindage électrique (115, 215, 315) de la première paire de bobines,
et dans lequel un noyau (180) des bobines de type Rogowski des première et deuxième paires a une perméabilité relative inférieure à 10 et dans lequel, une bobine de chaque paire comprend au moins un enroulement multi-spires, l'autre bobine de la paire comprenant au moins un enroulement multi-spires enroulé en sens opposé.

2. Capteur selon la revendication 1 dans lequel les bobines de type Rogowski de la première paire comprennent un nombre pair de couches d'enroulement multi-spires.

3. Capteur selon la revendication 1 ou 2 comprenant également au moins un moyen de filtrage (216) d'un mode commun de la première paire placé à des bornes de la première paire.

4. Capteur selon l'une quelconque des revendications 1 à 3 comprenant également au moins un moyen de filtrage (226) d'un mode commun de la deuxième paire placé à des bornes de la deuxième paire.

5. Capteur selon l'une quelconque des revendications 1 à 4 comprenant également :
- Un premier filtre de type HOKA (313) dont au moins une entrée est reliée à la première paire; et
- Un second filtre de type HOKA (323) dont les entrées sont reliées à la deuxième paire et à une sortie du premier filtre de type HOKA.

6. Capteur selon la revendication 5 comprenant également un capteur de courant continu (330) dont une sortie est placée en entrée du premier filtre de type HOKA (313), le capteur de courant continu étant apte à mesurer un courant continu dans ledit conducteur.

7. Capteur selon l'une quelconque des revendications 1 à 6 dans lequel les première et deuxième paires sont présentes sur au moins un circuit imprimé.

8. Capteur selon l'une quelconque des revendications 1 à 6 dans lequel les première et deuxième paires sont présentes sur au moins un support souple.

9. Procédé de mesure d'un courant électrique à large bande circulant dans un conducteur mis en oeuvre par le capteur de courant électrique selon l'une quelconque des revendications 1 à 8, comprenant :
- un enroulement des bobines de type Rogowski des première et deuxième paires autour dudit conducteur ;
- une première mesure de courant dans une première bande de fréquence ;
- une deuxième mesure de courant dans une deuxième bande de fréquence, la deuxième bande de fréquence comprenant au moins en partie des fréquences supérieures aux fréquences de la première bande de fréquence ; et
- une combinaison des deux mesures de courant afin de déterminer une mesure de courant sur une bande de fréquence comprenant la première bande de fréquence et la deuxième bande de fréquence.

## Patentansprüche

1. Sensor (100, 300) zur Messung eines elektrischen Stroms (I), der in einem Leiter (COND) zirkuliert, umfassend:
- ein erstes Paar (110, 210, 310) Rogowski-Spulen (111, 112, 211, 212, 311, 312), die in Serie verbunden sind, wobei die Rogowski-Spulen des ersten Paares dazu ausgestaltet sind, den elektrischen Strom (I) in einem ersten Frequenzband zu messen,
- ein zweites Paar (120, 220, 320) Rogowski-Spulen (121, 122, 221, 222, 321, 322), die in Serie verbunden sind, wobei die Rogowski-Spulen des zweiten Paares dazu ausgestaltet sind, den elektrischen Strom (i) in einem zweiten Frequenzband zu messen, wobei das zweite Frequenzband zumindest zum Teil Frequenzen umfasst, die höher sind als die Frequenzen des ersten Frequenzbandes, und
- ein Mittel zur elektrischen Abschirmung (115, 215, 315) des ersten Spulenpaares,
und wobei ein Kern (180) der Rogowski-Spulen des ersten und zweiten Paares eine relative Durchlässigkeit von weniger als 10 aufweist und wobei eine Spule von jedem Paar mindestens eine Wicklung mit mehreren Windungen umfasst, wobei die andere Spule des Paares mindestens eine Wicklung mit mehreren Windungen umfasst, die im entgegengesetzten Sinn gewickelt sind.

2. Sensor nach Anspruch 1, wobei die Rogowski-Spulen des ersten Paares eine gerade Zahl von Lagen der Wicklung mit mehreren Windungen umfassen.

3. Sensor nach Anspruch 1 oder 2, der ferner mindestens eine Gleichtaktfiltereinrichtung (216) des ersten Paares umfasst, die an Anschlüssen des ersten Paares platziert ist.

4. Sensor nach einem der Ansprüche 1 bis 3, der ferner mindestens eine Gleichtaktfiltereinrichtung (226) des zweiten Paares umfasst, die an Anschlüssen des zweiten Paares platziert ist.

5. Sensor nach einem der Ansprüche 1 bis 4, ferner umfassend:
- einen ersten HOKA-Filter (313), von welchem mindestens ein Eingang mit dem ersten Paar verbunden ist, und
- einen zweiten HOKA-Filter (323), dessen Eingänge mit dem zweiten Paar und mit einem Ausgang des ersten HOKA-Filters verbunden sind.

6. Sensor nach Anspruch 5, der ferner einen Gleichstromsensor (330) umfasst, von welchem ein Ausgang an dem Eingang des ersten HOKA-Filters (313) platziert ist, wobei der Gleichstromsensor dazu geeignet ist, einen Gleichstrom in dem Leiter zu messen.

7. Sensor nach einem der Ansprüche 1 bis 6, wobei das erste und zweite Paar auf mindestens einer Leiterplatte vorhanden sind.

8. Sensor nach einem der Ansprüche 1 bis 6, wobei das erste und zweite Paar auf mindestens einem flexiblen Träger vorhanden sind.

9. Verfahren zur Messung eines elektrischen Stroms mit großer Bandbreite, der in einem Leiter zirkuliert, wobei das Verfahren durch den elektrischen Stromsensor nach einem der Ansprüche 1 bis 8 umgesetzt wird, umfassend:
- eine Wicklung der Rogowski-Spulen des ersten und zweiten Paares um den Leiter herum,
- eine erste Messung des Stroms in einem ersten Frequenzband,
- eine zweite Messung des Stroms in einem zweiten Frequenzband, wobei das zweite Frequenzband zumindest zum Teil Frequenzen umfasst, die höher sind als die Frequenzen des ersten Frequenzbandes, und
- eine Kombination aus zwei Strommessungen, um eine Strommessung in einem Frequenzband zu bestimmen, welches das erste Frequenzband und das zweite Frequenzband umfasst.

## Claims

1. A sensor (100, 300) for measuring an electric current (I) flowing in a conductor (COND) comprising:
- a first pair (110, 210, 310) of Rogowski-type coils (111, 112, 211, 212, 311, 312) connected in series, the Rogowski-type coils of the first pair being configured to measure the electric current (I) in a first frequency band;
- a second pair (120, 220, 320) of Rogowski-type coils (121, 122, 221, 222, 321, 322) connected in series, the Rogowski-type coils of the second pair being configured to measure the electric current (I) in a second frequency band, the second frequency band comprising at least partly frequencies higher than the frequencies of the first frequency band; and
- a means for electrically shielding (115, 215, 315) the first pair of coils,
and wherein a core (180) of the Rogowski-type coils of the first and second pairs has a relative permeability of less than 10 and wherein one coil of each pair comprises at least one multi-turn winding, the other coil of the pair comprising at least one multi-turn winding wound in the opposite direction.

2. The sensor according to claim 1 wherein the Rogowski-type coils of the first pair comprise an even number of multi-turn winding layers.

3. The sensor according to claim 1 or 2 also comprising at least one means for filtering (216) a common mode of the first pair placed across terminals of the first pair.

4. The sensor according to any one of claims 1 to 3 also comprising at least one means for filtering (226) a common mode of the second pair placed across terminals of the second pair.

5. The sensor according to any one of claims 1 to 4 also comprising:
- a first HOKA-type filter (313), at least one input of which is connected to the first pair; and
- a second HOKA-type filter (323) whose inputs are connected to the second pair and to an output of the first HOKA-type filter.

6. The sensor according to claim 5 also comprising a direct current sensor (330) whose output is placed at the input of the first HOKA-type filter (313), the direct current sensor being able to measure a direct current in said conductor.

7. The sensor according to any one of claims 1 to 6 wherein the first and second pairs are present on at least one printed circuit.

8. The sensor according to any one of claims 1 to 6 wherein the first and second pairs are present on at least one flexible support.

9. A method for measuring a high bandwidth electric current flowing in a conductor implemented by the electric current sensor according to any one of claims 1 to 8, comprising:
- a winding of the Rogowski-type coils of the first and second pairs around said conductor;
- a first current measurement in a first frequency band;
- a second current measurement in a second frequency band, the second frequency band comprising at least partly frequencies higher than the frequencies of the first frequency band; and
- a combination of the two current measurements in order to determine a current measurement on a frequency band comprising the first frequency band and the second frequency band.
